(19) **Europäisches Patentamt / European Patent Office / Office européen des brevets**

(11) **EP 2 289 172 B1**

(12) **FASCICULE DE BREVET EUROPEEN**

(45) Date de publication et mention de la délivrance du brevet:
**04.07.2018 Bulletin 2018/27**

(21) Numéro de dépôt: **09769447.5**

(22) Date de dépôt: **27.05.2009**

(51) Int Cl.:
**H03M 7/30** *(2006.01)*

(86) Numéro de dépôt international:
**PCT/FR2009/000618**

(87) Numéro de publication internationale:
**WO 2009/156606 (30.12.2009 Gazette 2009/53)**

(54) **PROCÉDÉ DE DÉNOMBREMENT DES VECTEURS DANS LES RÉSEAUX RÉGULIERS DE POINTS**

VERFAHREN ZUR AUFZÄHUNG VON VEKTOREN IN EINEM REGULÄREM PUNKTEGITTER

METHOD FOR ENUMERATION OF VECTORS IN A REGULAR LATTICE OF POINTS

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **02.06.2008 FR 0803020**

(43) Date de publication de la demande:
**02.03.2011 Bulletin 2011/09**

(73) Titulaires:
- **Centre National de la Recherche Scientifique (C.N.R.S.)**
  **75794 Paris Cedex 16 (FR)**
- **Université de Nice Sophia Antipolis**
  **06108 Nice Cedex 2 (FR)**

(72) Inventeurs:
- **ANTONINI, Marc**
  **F-06200 Nice (FR)**
- **HIDD FONTELES, Leonardo**
  **F-06200 Nice (FR)**

(74) Mandataire: **Novagraaf Technologies**
**Bâtiment O2**
**2, rue Sarah Bernhardt**
**CS90017**
**92665 Asnières-sur-Seine Cedex (FR)**

(56) Documents cités:
**WO-A-99/33185     US-A1- 2005 285 764**

- **PIERRE LOYER ET AL: "Lattice Codebook Enumeration for Generalized Gaussian Source" IEEE TRANSACTIONS ON INFORMATION THEORY, IEEE, US, vol. 49, no. 2, 1 février 2003 (2003-02-01), XP011074685 ISSN: 0018-9448**

EP 2 289 172 B1

**Description**

La présente invention concerne le domaine du traitement de données numériques en vue d'application telles que la compression de données numériques, la recherche de données numériques, la comparaison de données numériques ou la décompression de données numériques. L'invention concerne le traitement de données audiovisuelles, et plus généralement tout type de données numériques. Le but visé par l'invention est de réduire les temps de traitement et les besoins de ressources informatiques tant en ce qui concerne la puissance de calcul que les besoins de mémoire.

Les applications concernent notamment mais non exclusivement le traitement d'images nécessitant un très grand nombre de données pour la décrire. Pour réduire la durée de transmission et la taille requise pour le stockage, on réalise une compression de l'information en procédant à une extraction de l'information visuelle qui seule sera codée. Cette information codée doit être localisée de manière optimale en fréquence et dans l'espace pour permettre une restitution optimale en évitant toute redondance néfaste aux performances du codage. Pour cela, il est connu de mettre en oeuvre la technique de transformée par ondelette, dont les coordonnées constituent un réseau vectoriel qui est ensuite soumis à une étape de quantification vectorielle.

Le principe de la quantification vectorielle (VQ) est de coder une séquence d'échantillons formant un vecteur au lieu de coder chacun des échantillons individuellement. Le codage s'effectue en approximant la séquence à coder par un vecteur appartenant à un catalogue de formes usuellement appelé «codebook». Chacun des vecteurs du codebook est indexé. Lors du codage, c'est l'index du vecteur le plus proche de la séquence d'échantillons à coder, qui servira à la représenter.

Les solutions connues nécessitent la détermination de chacun des vecteurs, leur enregistrement dans une mémoire et l'exécution ensuite de traitement sur l'ensemble des vecteurs pour les dénombrer. La base de vecteurs peut nécessiter plusieurs gigaoctets, et les temps de calcul pour une base aussi importante sont importants. Le but de l'invention est de proposer un procédé de dénombrement et d'indexage évitant ces inconvénients.

<u>État de la technique</u>

On connaît dans l'état de la technique la demande de brevet international WO9933185 concernant un procédé de codage consistant à déterminer un vecteur, dit vecteur leader, qui comporte les mêmes composantes que le vecteur quantifié mais dans un ordre prédéterminé, puis à déterminer le niveau d'ordre ou rang dudit vecteur quantifié dans ledit ensemble formé des vecteurs qui ont les mêmes composantes que le vecteur leader et qui sont, dans ledit ensemble, ordonnés de manière prédéterminée. Le procédé consiste ensuite à former un code à partir, d'une part, d'un indice représentatif dudit vecteur leader ainsi déterminé et, d'autre part, dudit rang. On connait aussi l'article "Lattice Codebook Enumeration for Generalised Gaussian Source" (P. Loyer et al., IEEE Transactions on Information Theory. vol 49, no. 2, 2003) dans l'état de la technique qui divulgue un procédé de quantification pour des sources de type gaussienne. La difficulté principale rencontrée pour la conception d'un quantificateur vectoriel algébrique pour la compression est liée au problème de dénombrement et d'indexage des vecteurs dans le réseau régulier de points (qui constitue le dictionnaire de quantification). Nous présentons ici les solutions que nous avons proposées pour résoudre ces problèmes dans le cas d'une source de distribution Gaussienne généralisée (comme par exemple les coefficients d'ondelettes).

La quantification vectorielle algébrique

La quantification a été étudiée depuis quelques dizaines d'années maintenant et les travaux effectués ont développé de nombreux résultats aujourd'hui classiques sur la théorie débit-distorsion. En particulier, il a été montré que la Quantification Vectorielle (QV) possède de nombreux avantages par rapport à la Quantification Scalaire (QS) lorsqu'un codage à longueur fixe est imposé. De plus, les travaux de Shannon ont montré que les performances de la QV sont proches des performances théoriques optimales si la dimension n des vecteurs de quantification est suffisamment grande.

Cependant, il est important de noter que la QV peut se rapprocher de ces performances optimales au prix d'une complexité calculatoire élevée ; complexité qui augmente de façon exponentielle avec la dimension des vecteurs. Généralement, la QV est effectuée en utilisant un dictionnaire non structuré construit à partir de données statistiques représentatives de la source (séquence d'apprentissage). Dans ce cas, la complexité ainsi que les besoins en stockage dus à la taille du dictionnaire peuvent devenir prohibitifs pour des applications de compression. De plus, il existe un problème de robustesse du dictionnaire qui, optimisé pour une séquence d'apprentissage donnée, donne des performances mauvaises pour une image en dehors de la séquence d'apprentissage. Une solution pour surmonter ces problèmes est d'utiliser un QV structuré n-dimensionnel tel que la Quantification Vectorielle Algébrique (QVA) ou encore quantification vectorielle sur réseaux réguliers de points. Comme les vecteurs du dictionnaire sont contraints à appartenir à un réseau régulier structuré, les performances de la QVA sont en général inférieures à celle de la QV non-structurée.

Mais dans la plupart des applications, ce léger désavantage est compensé par le fait que pour la QVA aucun dictionnaire a besoin d'être généré ou stocké, et que la complexité de codage est réduite.

La quantification par réseaux réguliers de points peut être vue comme une généralisation de la quantification scalaire uniforme. Comme dans le cas de la QV non structurée, le terme QVA sera utilisé dans le reste du document soit pour désigner la quantification vectorielle, soit pour désigner un quantificateur vectoriel. La QVA prend en compte les dépendances spatiales entre les coefficients des vecteurs ainsi que les gains de partitionnement et de forme. Quelle que soit la distribution de la source, la QVA est toujours plus efficace que la QS.

Un réseau régulier de points dans $R^n$ est composé par toutes les combinaisons possibles d'un ensemble de vecteurs linéairement indépendants $a_i$ qui constitue la base du réseau $\{y|y = u_1a_1 + u_2a_2 + ... + u_na_n\}$ où les coefficients $u_i$ sont des entiers. La partition de l'espace est alors régulière et ne dépend seulement que des vecteurs de base choisis. Chaque base définie un réseau régulier de points différent. La QVA offre la possibilité de réduire considérablement les coûts calcul et stockage par rapport à un QV conçu au moyen d'algorithmes basés sur l'algorithme de Lloyd généralisé. En effet, utiliser les vecteurs d'un réseau régulier comme valeurs de quantification élimine l'opération de construction d'un dictionnaire : le dictionnaire est construit implicitement de par la structure du réseau choisi. L'article Conway et Sloane « Fast quantizing and decoding algorithms for lattice quantizers and codes » paru dans IEEE Trans. On Information Theory, vol. 28, n°2, pp.227-232 mars 1982 décrit des algorithmes rapides de quantification qui utilisent simplement des opérations d'arrondis et qui ne dépendent que de la dimension n des vecteurs. En 1979, Gersho a émis la conjecture que dans le cas asymptotique (c'est-à-dire pour des forts débits), les performances débit-distorsion d'un QVA sont approximativement optimales. Toutefois, bien que la QVA ne soit pas mathématiquement optimale pour des faibles débits, la réduction de complexité apportée par de tels quantificateurs permet d'utiliser de grandes dimensions de vecteurs, ce qui entraîne de meilleures performances expérimentales à débit donné. De bonnes performances débit-distorsion peuvent être obtenues en combinant la QVA avec un codeur entropique, ce qui a motivé quelques travaux sur la QVA dans le domaine des ondelettes. Beaucoup de travaux théoriques sur la QV ont été menés pour des sources Gaussienne et Laplacienne, cependant, dans le cas de sources de type Gaussienne généralisée avec un paramètre de décroissance inférieur à un, il a été montré par que le réseau cubique $Z^n$ était plus performant en termes de débit-distorsion que le réseau $E_8$ et le réseau de Leech. Ce résultat a motivé nos travaux pour combiner la QVA avec la transformée en ondelettes.

Les problématiques traitées par l'invention

Si la quantification par QVA est peu complexe, du fait de la structure géométrique régulière du dictionnaire, sa mise en oeuvre n'est cependant pas immédiate. Dans le cas de modèles non-asymptotiques, le bruit de surcharge est négligé puisque nous supposons l'utilisation d'un codage à longueur variable et d'un dictionnaire infini. Elle soulève en effet un certain nombre de questions concrètes, notamment en termes de calcul et de stockage. Deux problèmes fondamentaux peuvent être mis en avant dans la conception d'un QVA :

a) L'indexage : L'indexage est une opération indépendante de la quantification, elle consiste à assigner à chaque vecteur quantifié, un indice (ou index) qui, une fois codé, est transmis sur un canal jusqu'au décodeur. Cette opération est fondamentale dans la chaîne de compression. Elle conditionne en effet le débit binaire et permet le décodage sans ambiguïté des vecteurs. Les méthodes connues sont généralement très peu coûteuses en mémoire, mais présentent une complexité calculatoire non négligeable (algorithmes récursifs), ou fonctionnent seulement dans des cas particuliers (types de réseau ou de troncature particuliers). L'invention concerne une approche plus générale qui permet l'indexage sur des distributions de type Gaussienne généralisée, réalisant un bon compromis coût mémoire/coût calcul. Le premier brevet propose une solution à cette problématique.

b) Le dénombrement. Les méthodes d'indexage sont généralement basées sur la connaissance de la population du réseau. Ainsi, nous devons être capable de dénombrer les vecteurs du réseau sur des surfaces (ou à l'intérieur de volumes) n-dimensionnels qui dépendent de la distribution de la source. Une approche classique de dénombrement est basée sur l'utilisation de séries génératrices. Dans ce formalisme, les fonctions Nu ont été introduites. Elles permettent le dénombrement sur des pyramides, c'est-à-dire dans le cas d'une distribution Laplacienne.

La présente invention concerne plus particulièrement l'étape de dénombrement sur des distributions de type Gaussienne généralisée, réalisant un bon compromis coût mémoire/coût calcul. Le deuxième brevet propose une solution à cette problématique. Notre contribution a porté principalement sur le dénombrement et l'indexage ainsi que sur la mise en oeuvre de QVA dans le cadre d'applications de compression d'images ou de vidéos. L'utilisation de ces deux approches et de la QVA reste tout à fait valide pour la compression du signal audio (son, parole, musique).

À cet effet, l'invention concerne selon son acception la plus générale un procédé d'estimation du nombre de vecteurs leaders de norme $l_p$ égal à $r_{\delta,d}^{p}$ de dimension d et dont les coordonnées sont inférieures ou égales à k, caractérisé en ce que $r_{\delta,d}^{p}$ est déterminé par la sommation des résultats d'une fonction $T(x_i)$ pour i variant entre 1 et d, ladite fonction $T(x_i)$ retournant, pour une partie au moins desdits vecteurs leaders, le résultat de la division de la coordonnée $x_i$ élevé à la puissance p par un facteur de précision delta, le résultat de ladite division étant arrondi à l'entier le plus proche, le procédé ne comportant pas d'étape de détermination des vecteurs leaders.

De préférence, on procède à la sommation, pour les valeurs de n comprises entre d et 1, du résultat de la fonction $\overline{q}_{\delta}^{p}(r-T(u), n-1, u)$, en faisant varier u entre une valeur minimale $u_{min}(r, n)$ et k, ladite fonction $\overline{q}_{\delta}^{p}(r, n, k)$ retournant la quantité de vecteurs leaders de norme $r_{\delta,n}^{p} = r$, de dimension n et dont les coordonnées sont inférieures ou égale à k, ladite fonction $u_{min}$ retournant la plus petite valeur entière u qui vérifie $T(u)$ supérieur ou égal à r/n.

Avantageusement, on procède à une étape préalable d'initialisation consistant à attribuer, pour n=1, à la fonction $\overline{q}_{\delta}^{p}(r, 1, k)$ une valeur correspondant au nombre des valeurs possibles de u plus petites ou égales à k telles que $T(u)=r$, puis à procéder à ladite étape de sommation.

L'invention concerne également une application du procédé d'estimation pour l'estimation du débit dans le cadre de compression de données ou pour l'indexation de vecteurs leaders.

## Description détaillée de l'invention

L'invention sera mieux comprise à la lecture d'un exemple non limitatif de réalisation, se référant aux dessins annexés où :

- la figure 1 représente un exemple d'enveloppe de $r_{\delta,2}^{p} = 15$, p = 0,4 et δ = 0,3 pour un réseau Z2
- la figure 2 représente comparaison des besoins de mémoire entre la méthode usuelle et la méthode proposée pour p = 1, δ = 1 et B = 4.
- les annexes 1 et 2 représentent deux exemples d'algorithmes de dénombrement pour la mise en oeuvre de l'invention.

L'indexage de vecteurs de réseau est un problème essentiel dans les applications de quantification de réseau. L'invention concerne une solution à ce problème utilisant les vecteurs leaders de réseau et le cadre de la théorie des partitions. Elle fonctionne pour des sources de distribution Gaussienne généralisée et permet l'utilisation de codes produit. Elle permet également de dénombrer des vecteurs de dimension élevée.

La quantification vectorielle (QV) pourrait permettre d'obtenir des performances théoriques optimales si la dimension vectorielle est arbitrairement élevée. Malheureusement, la complexité de calcul de QV non structurée optimale telle que LBG augmente de façon exponentielle avec la dimension. De plus, les besoins en stockage peuvent être très importants. Une solution à ce problème de dimensionnalité est l'utilisation de QV contrainte telle que la quantification vectorielle de réseau (LVQ).

L'approche LVQ conduit à la conception d'un dictionnaire structuré dont les vecteurs de code sont régulièrement distribués dans l'espace. Par conséquent, au lieu d'optimiser la position des vecteurs dans l'espace, il est possible d'adapter la source en indexant les vecteurs de réseau conformément à la forme de sa distribution. Pour la plupart des sources de données réelles ceci peut être effectué efficacement en utilisant un code produit, conduisant à un compromis débit-distorsion optimal pour des distributions de sources unimodales symétriques.

En effet, il est possible d'interpréter de telles distributions comme étant un ensemble d'hypersurfaces concentriques ayant la même forme en fonction de la distribution de source. Il est alors possible d'indexer les mots de code de réseau en assignant un premier index (préfixe) correspondant à la norme (rayon) de la surface respective et un second index unique (suffixe) correspondant au dénombrement des vecteurs appartenant à une même surface.

Un grand nombre de sources de données importantes, telles que des coefficients d'image et de parole sous-bande, en particulier ceux obtenus par transformation d'ondelette, peuvent être modélisées par les distributions Gaussiennes généralisées. Cette famille de distributions est paramétrée par un facteur de forme unique p (GG(p)) pour une variable stochastique univariée. Une propriété intéressante des sources ayant des distributions (GG(p)) est que les enveloppes de norme $l_p$ correspondant à des surfaces de probabilité constante. Ceci conduit au développement de codes produit effectifs.

Même si le calcul du préfixe est trivial, le suffixe requiert le dénombrement et l'indexage des vecteurs de réseau situés sur des hypersurfaces données. De plus, l'augmentation de la dimension de l'espace peut rendre l'opération d'indexage et dénombrement très complexe, étant donné que le nombre de vecteurs situés sur une enveloppe augmente fortement avec la norme, comme l'illustre le tableau ci-dessous, représentant la comparaison du nombre de leaders d'une hyperpyramide donnée et du nombre total de vecteurs de réseau situés sur cette hyperpyramide (cardinalité) dans le cas d'une norme $l_1$, pour un réseau $Z^n$ et différentes valeurs de dimension et de norme.

| Dimension | Norme | Nombre de leaders | Cardinalité |
|---|---|---|---|
| 3 | 10 | 13 | 402 |
| | 400 | 884 | 640002 |
| | 1000 | 83834 | 4000002 |
| 9 | 10 | 41 | 1854882 |
| | 172 | $1,37 \cdot 108$ | $9,74 \cdot 10^{15}$ |
| | 1842 | $9,98 \cdot 1015$ | $1,68 \cdot 1024$ |
| 18 | 10 | 42 | 317222212 |
| | 29 | 4426 | $8,42 \cdot 10^{15}$ |
| | 450 | $9,89 \cdot 1015$ | $9,39 \cdot 10^{15}$ |
| 60 | 5 | 7 | 207648024 |
| | 11 | 56 | $1,90 \cdot 10^{15}$ |
| | 303 | $9,88 \cdot 1015$ | $2,54 \cdot 10^{15}$ |
| 120 | 4 | 5 | 138259200 |
| | 9 | 30 | $7,30 \cdot 10^{15}$ |
| | 301 | $9,92 \cdot 1015$ | $9,50 \cdot 10^{34}$ |
| 240 | 3 | 3 | 18432160 |
| | 7 | 15 | $1,17 \cdot 10^{15}$ |
| | 301 | $9,93 \cdot 1015$ | $1,68 \cdot 10^{203}$ |

Dans la littérature, l'indexage du suffixe est généralement effectué selon deux techniques différentes.

La première attribue un index tenant compte du nombre total de vecteurs situés sur une hypersurface donnée (cardinalité). Une autre approche exploite les symétries d'un réseau en utilisant le concept de leaders. Les leaders d'une enveloppe de norme $l_p$ correspondent à quelques vecteurs de réseau à partir desquels tous les autres vecteurs de réseau situés sur l'enveloppe correspondante peuvent être obtenus par des permutations et des changements de signe de leurs coordonnées. Ces deux approches ont tendance à présenter des performances débit-distorsion similaires pour des sources isotropes.

Cependant, la plupart des travaux sur l'indexage de réseau proposent des solutions uniquement pour des distributions Laplaciennes ou Gaussiennes, qui sont des cas particuliers de GG(p), avec des paramètres de forme p = 1 et p = 2, respectivement. Quelques auteurs proposent une solution pour le cas particulier p = 0,5. Toutefois, cette méthode de dénombrement ne permet pas la construction de codes produit et la méthode d'indexage dans est très complexe dans la pratique, en particulier pour p ≠ 0,5, 1 ou 2 avec des dimensions et des normes élevées.

L'invention propose une nouvelle alternative pour le dénombrement de vecteurs de réseau $Z^n$ situés sur des enveloppes GG(p) avec 0 < p ≤ 2 pour des méthodes d'indexage du type leaders et utilise la théorie des partitions. L'utilisation de la théorie des partitions nous a permis de surmonter la complexité et les besoins en stockage pour générer et indexer les leaders. Nous proposons un algorithme de dénombrement économique qui compte le nombre de leader sur une enveloppe de rayon r, dimension d et de coordonnée plus forte k pour des applications telles que l'indexage de leaders, estimation de débit entre autres.

Dans la description qui suit, une première partie présente le principe de la LVQ et décrit le problème de l'indexage/dénombrement. Une deuxième partie propose une solution efficace pour dénombrer des livres de code LVQ de très grande taille, quel que soit le paramètre de forme p. La description précise ensuite le coût en mémoire de l'approche proposée.

2. Indexage de vecteurs de réseau

2.1 Définition d'un réseau

Un réseau $\Lambda$ dans $R^n$ est composé de toute combinaison intégrale d'un ensemble de vecteurs linéairement indépendants $a_i$ (la base du réseau) telle que :

$$\Lambda = \{x \mid x = u_1 a_1 + u_2 a_2 + \dots u_n a_n\}$$

$$(1)$$

où les $u_i$ sont des entiers. La partition de l'espace est donc régulière et dépend uniquement des vecteurs de base choisis $a_i \in R^m$ ($m \geq n$). Il doit être noté que chaque ensemble de vecteurs de base définit un réseau différent.

Chaque vecteur **v** d'un réseau peut être considéré comme appartenant à une surface ou hypersurface contenant des vecteurs ayant une norme $l_p$ constante donnée par :

$$\|\mathbf{v}\|_p = \left( \sum_{i=1}^{n} |v_i|^p \right)^{\frac{1}{p}}.$$

Il est alors possible de coder un vecteur de réseau donné en utilisant un code produit. Il apparaît clairement que si la distribution des vecteurs sources est Laplacienne un code produit approprié est constitué d'un préfixe correspondant à la norme $l_1$ d'un vecteur et d'un suffixe correspondant à sa position sur l'hyperpyramide avec un rayon égal à la norme $l_1$ en question. Les hypersurfaces de norme $l_1$ constante sont appelées hyperpyramides. La position du vecteur sur une hypersurface peut être obtenue en utilisant un algorithme de dénombrement. Un tel code produit assure l'unicité pour le décodage.

Dans le cas de sources ayant une distribution Gaussienne généralisée avec un paramètre de forme inférieur ou égal à un, la supériorité du réseau $Z^n$ cubique sur $D_4$, $E_8$ ou des réseaux de Leech a été démontrée [12]. Par conséquent, la suite de ce document est focalisée sur la conception d'une LVQ basée sur le réseau $Z^n$ cubique.

2.2 Indexage basé sur un dénombrement total

On connaît dans l'état de la technique plusieurs solutions de dénombrement ont été proposées pour le cas de distributions Gaussiennes ou Laplaciennes et pour différents réseaux basés sur le principe d'un dénombrement total. On connaît notamment, dans le cas d'une distribution de source Laplacienne et pour un réseau $Z^n$, une formule récursive pour calculer le nombre total de vecteurs de réseau situés sur une hyperpyramide de norme $l_1$. Cette formule de dénombrement a été étendue à des distributions de source Gaussiennes généralisées avec un facteur de forme p compris entre 0 et 2. Ces solutions permettent de déterminer le nombre de vecteurs situés à l'intérieur d'une norme de troncature $l_p$ donnée, mais ils ne proposent pas un algorithme pour assigner un index effectif aux vecteurs du réseau $Z^n$. De plus, cette solution ne détermine pas le nombre de vecteurs situés sur une hypersurface donnée, ce qui rend difficile l'utilisation de codes produit.

L'algorithme proposé dans les travaux de l'état de l'art indexe les vecteurs conformément au schéma de code produit pour $0 < p \leq 2$. Il est basé sur les séries thêta généralisées [4] et exploite la géométrie du réseau. Pour p = 1 ou 2, le développement de cette série est relativement simple. Cependant, pour d'autres valeurs de p, le développement de cette série est très complexe, étant donné qu'aucune forme fermée n'est produite et l'utilisation de mathématiques formelles est prohibitive. Avec la solution proposée, il est nécessaire de déterminer chaque valeur de norme possible pour les différentes dimensions et pour des dimensions élevées, ce qui tend à être infaisable dans un temps fini.

De plus, étant donné que la cardinalité d'une hypersurface peut rapidement atteindre des valeurs non tractables pour des mises en oeuvre pratiques, en particulier pour des dimensions élevées (voir Tableau ci-dessus), les techniques d'indexage basées sur la cardinalité de l'enveloppe peuvent rapidement dépasser la précision informatique.

2.3 Indexage à base de leaders

Les méthodes basées sur des leaders tirent profit des symétries du réseau. Elles utilisent un algorithme d'indexage efficace sur les enveloppes de norme constante et n'attribuent pas l'index sur la base du nombre total de vecteurs du réseau, mais sur la base d'un faible nombre de vecteurs appelés leaders. Les différentes symétries du réseau sont traitées séparément ce qui, par rapport aux techniques de dénombrement total, constitue une méthode plus efficace d'indexage de sources lorsque les symétries ne sont pas toutes présentes. De plus, les index gérés par l'algorithme de codage sont beaucoup plus faibles que la cardinalité de l'enveloppe, ce qui permet d'indexer des vecteurs qui ne pourraient pas être indexés par des méthodes basées sur un dénombrement total pour une précision binaire donnée.

Dans l'architecture de code produit, outre les symétries du réseau, l'index suffixe contient l'index d'un faible nombre de vecteurs (leaders) à partir desquels tous les autres vecteurs de l'hypersurface peuvent être assignés. Pour

le réseau $Z^n$, les symétries correspondent à deux opérations basiques : des changements de signe et des permutations des coordonnées vectorielles. La première opération correspond à un changement de l'octant où est situé le vecteur. Par exemple, le vecteur (7, -3) de dimension 2 est dans le quatrième octant, tandis que le vecteur (-7, -3) est dans le troisième. Ces vecteurs sont symétriques par rapport à l'axe y. La seconde opération correspond à la symétrie intra-octant lorsque, par exemple, les vecteurs (-7, 3) et (-3, 7) sont tous deux dans le deuxième octant et symétriques par rapport à la bissectrice de l'octant. Dans ce cas, il peut être observé que tous ces vecteurs peuvent être générés à partir de permutations et de changements de signe du vecteur (3, 7), qui est le leader de tous ces vecteurs. Avec l'ensemble des permutations et changements de signe, le leader (3, 7) peut représenter 8 vecteurs. Ce rapport augmente rapidement avec la dimension de l'hypersurface (voir Tableau 1).

Par conséquent, au lieu d'indexer directement tous les vecteurs sur une hypersurface, cette méthode d'indexage assigne à chaque vecteur un ensemble de trois index : l'un correspondant à son leader et les deux autres correspondant à sa permutation et aux changements de signe du leader. Pour plus de détails sur la méthode de calcul des index de permutation et de signe voir l' [5].

## 3. Méthode de dénombrement proposé

L'invention propose une solution pour le dénombrement de leaders. Pour mieux comprendre le cadre d'utilisation d'un tel algorithme de dénombrement, nous donnerons par la suite un exemple non limitatif d'utilisation pour l'indexage des leaders. Dans un premier temps, nous parlerons de l'indexage pour une norme $l_1$ et dans un deuxième temps nous donnerons un exemple pour le cas le plus général de la norme $l_p$.

Ensuite, dans la section 3.3 nous détaillerons l'invention.

### 3.1 Indexation de leader pour la norme $l_1$

#### 3.1.1 Principe

La méthode d'indexage de leaders sur laquelle s'applique l'algorithme de dénombrement proposé est basée sur la classification de tous les leaders dans un ordre lexicographique inverse et attribue un index en fonction du nombre de leaders précédant le leader devant être indexé. Dans ce cas, l'indexage n'est plus basé sur un algorithme de recherche à forte consommation de ressources ou un adressage direct, mais sur un algorithme de dénombrement à faible coût qui dépend uniquement de la quantité de leaders plutôt que de la connaissance explicite de chacun d'entre eux, ce qui permet d'éviter la construction de tables de conversion.

Une hyperpyramide de rayon r est composée de tous les vecteurs $v = (v_1, v_2, ..., v_d)$ de sorte que $\|v\|_1 = r$. Comme décrit précédemment, les leaders sont les vecteurs élémentaires d'une hypersurface à partir desquels des opérations de permutations et de changements de signe conduisent à tous les autres vecteurs situés sur cette hypersurface. En effet, les leaders sont des vecteurs ayant des coordonnées positives triées dans l'ordre croissant (ou décroissant). Par conséquent, les leaders pour la norme $l_1$ égale à r et la dimension d sont des vecteurs qui satisfont aux conditions ci-dessous :

$$1- \sum_{i=1}^{d} v_i = r \ ;$$

$$2 - 0 \le v_i \le v_j, \text{ pour } i < j \text{ et } i, j \in [1, d].$$

### 3.1.2 Lien avec la théorie des partitions

Dans le cas d'une norme $l_1$, on peut noter que les conditions présentées dans la section 3.1.1 sont liées à la théorie des partitions dans la théorie des nombres. En effet, dans la théorie des nombres, une partition d'un entier positif r est une façon d'écrire r comme étant une somme de d entiers positifs (également appelée part). Le nombre de partitions distinctes (et indépendantes de l'ordre) de r est donné par la fonction de partition P(r) de sorte que :

$$\sum_{r=0}^{\infty} P(r)y^r = \prod_{d=1}^{\infty} \left( \frac{1}{1-y^d} \right), \tag{2}$$

qui correspond à la réciproque de la fonction d'Euler, également appelée série q [10, 16, 17]. Des développements mathématiques supplémentaires conduisent à des représentations de la fonction P(r) permettant d'accélérer les calculs.

Par exemple, pour r = 5, l'équation (2) donne le résultat P(5) = 7. En effet, toutes les partitions possibles du nombre 5 sont (5), (1, 4), (2, 3), (1, 1, 3), (1, 2, 2), (1, 1, 1, 2) et (1, 1, 1, 1, 1). En réécrivant ces partitions sous forme de vecteurs de dimension 5 tels que (0, 0, 0, 0, 5), (0, 0, 0, 1, 4), (0, 0, 0, 2, 3), (0, 0, 1, 1, 3), (0, 0, 1, 2, 2), (0, 1, 1, 1, 2) et (1, 1, 1, 1, 1), nous observons que ceux-ci correspondent exactement aux leaders de l'hyperpyramide de norme r = 5 et de dimension d = 5, c'est-à-dire que ce sont les seuls vecteurs dans l'hyperpyramide de norme r = 5 et de dimension d = 5 qui satisfont aux deux conditions de la section 3.1.1.

Cependant, nous nous intéressons généralement à des enveloppes de norme 11 égale à r dans un réseau d-dimensionnel avec r ≠ d. Dans ce cas, il est possible d'utiliser la fonction q(r, d) [10, 18] qui calcule le nombre de partitions de r avec au plus d parts (dans la théorie des partitions ceci équivaut à calculer le nombre de partitions de r ne comportant aucun élément supérieur à d avec un nombre quelconque de parts). Par conséquent, pour une hyperpyramide de norme r = 5 et de dimension d = 3, nous avons q(5, 3) = 5, c'est-à-dire, cinq leaders donnés par : (0, 0, 5), (0, 1, 4), (0, 2, 3), (1, 1, 3) et (1, 2, 2).

La fonction q(r, d) peut être calculée à partir de la relation de récurrence:

$$q(r, d) = q(r, d - 1) + q(r - d, d)$$

$$(3)$$

avec q(r, d) = P(r) pour d ≥ r, q(1, d) = 1 et q(r, 0) = 0.

3.1.3 Utilisation de la fonction q(r, d) pour indexer les leaders

Comme décrit ci-après, non seulement l'équation (3) donne le nombre total de leaders situés sur une hyperpyramide donnée, mais elle peut également être utilisée pour attribuer à la volée des indices uniques pour les leaders, sans nécessiter des tables de conversion. Afin d'illustrer le principe de l'algorithme d'indexage, supposons que les leaders d'une hyperpyramide donnée sont classés dans l'ordre lexicographique inverse de la façon suivante :

| Valeur d'index | Leader |
|---|---|
| 0 | $(0, ..., 0, 0, r_n)$ |
| 1 | $(0, ..., 0, 1, r_n - 1)$ |
| 2 | $(0, ..., 0, 2, r_n - 2)$ |
| 3 | $(0, ..., 1, 1, r_n - 2)$ |
| . | . |
| . | . |
| . | . |

Ainsi, l'index d'un leader 1 correspond au nombre de leaders qui précèdent celui-ci. Dans l'exemple décrit ci-dessus, le leader $(0, ..., 1, 1, r_n - 2)$ doit être assigné à l'index 3.

La proposition mathématique numéro 1 décrit l'algorithme pour l'indexage de leader :

Proposition 1. Soit $\mathbf{v} = (v_1, v_2, ..., v_n)$ un vecteur de réseau $Z^n$ avec un leader $\mathbf{l} = (x_1, x_2, ..., x_n)$ situé sur une enveloppe de norme constante $l_1$. Son index de leader $l_1$ est donné par :

$$I_l = \sum_{\substack{j=0 \\ \text{tant que } x_{n-(j+1)} \neq 0}}^{n-2} \sum_{i=x_{n-j}+1}^{\min[x_{n-(j-1)}, r_{n-j}]} \overline{q}(r_{n-j} - i, n - (j+1), i)$$

$$(4)$$

où $\overline{q}(r, d, k)$ calcule le nombre de partitions de r avec au plus d parts inférieures ou égales à k, avec $\overline{q}(0, d, k) = 1$ et $x_{n+1} = +\infty$.

Démonstration. Considérons un leader $l = (x_1, x_2, ..., x_n)$ de dimension n et de norme $l_1$ $r_n = \sum_{i=1}^{n} x_i$ devant être indexé. Étant donné qu'on trie les leaders dans l'ordre lexicographique inverse, un premier groupe de leaders placés avant $l$ est composé de tous les leaders dont la n$^{ème}$ composante est strictement supérieure à $x_n$, c'est-à-dire, tous les leaders ayant la plus grande coordonnée $g_n$ satisfaisant à $x_n + 1 \leq g_n \leq r_n$.

Afin de compter le nombre de leaders de ce premier groupe sans les lister tous, nous utilisons la fonction de partition q(r, d). En effet, le nombre de leaders dont la n$^{ème}$ coordonnée est égale à $g_n$ peut être aisément calculé en utilisant la remarque suivante :

Remarque : le calcul du nombre de leaders de norme $r_n$ et de dimension n dont la plus grande coordonnée est égale à $g_n$ revient à calculer le nombre de partitions du nombre $r_n - g_n$ avec au plus n - 1 parts sans aucune part supérieure à $g_n$.

Dans la plupart des cas, nous pouvons compter ce nombre de partitions en appliquant $q(r_n - g_n, n - 1)$. Cependant, cette approche n'est valide que si $r_n - g_n \leq g_n$, auquel cas il est implicitement supposé que toutes les partitions de $r_n - g_n$ n'ont aucune part supérieure à $g_n$. Cependant, dans un cas plus général, dans lequel $r_n - g_n \leq g_n$ n'est pas garanti (par exemple, le nombre de leaders de norme $r_n$ = 20 et de dimension n = 5 avec la plus grande partie égale à 7 conduirait à q(20-7, 5-1) = q(13, 4), où 20 - 7 $\not\leq$ 7), le calcul de $q(r_n - g_n, n - 1)$ conduirait à un nombre erroné de leaders valides, étant donné que certaines partitions de $r_n - g_n$ auraient leur plus grande part supérieure à $g_n$, auquel cas la condition 2 dans la section 3.1.1 ne serait pas respectée.

Dans une telle situation, nous devons appliquer une deuxième contrainte au calcul du nombre de partitions : la valeur de la plus grande part. Nous introduisons alors une généralisation de q(r, d), donnée par la fonction $\overline{q}(r, d, k)$, qui calcule le nombre de partitions d'un nombre r donné avec au plus d parts sans aucune part supérieure à k. Le calcul de $\overline{q}(r, d, k)$ est fait à l'aide d'un algorithme de dénombrement, tel que celui qui fait l'objet de cette invention.

Par conséquent, nous pouvons calculer le nombre correct de leaders valides en appliquant $\overline{q}(r_n - g_n, n - 1, g_n)$. Ainsi, la variation de $g_n$ de $x_n + 1$ à $r_n$ permet de déterminer le nombre de leaders dont la plus grande coordonnée est strictement supérieure à $x_n$, donné par :

$$\sum_{i=x_n+1}^{r_n} \overline{q}(r_n - i, n - 1, i)$$

$$(5)$$

où nous supposons que $\overline{q}(0, d, k) = 1$, $\forall$ d $\in$ $Z^+$ et $\forall$ k $\in$ $Z^*$. Dans ce cas, nous utilisons la notation d'ensemble utilisée dans la théorie des nombres, où $Z^+$ représente l'ensemble d'entiers positifs {i $\in$ Z|i > 0} et $Z^*$ l'ensemble d'entiers non négatifs {i $\in$ Z|i $\geq$ 0}.

Un deuxième groupe de leaders précédant $l$ est composé de tous les leaders dont la n$^{ème}$ coordonnée est égale à $x_n$ mais avec une (n - 1)$^{ème}$ coordonnée strictement supérieure à $x_{n-1}$. Afin de compter ce nombre de leaders, nous pouvons utiliser la même remarque précédemment mentionnée, mais cette fois appliquée à la dimension n - 1. Nous pouvons alors calculer le nombre de leaders dont la plus grande composante $g_n = x_n$ et la deuxième plus grande composante $g_{n-1} > x_{n-1}$ en utilisant $\overline{q}((r_n - x_n) - g_{n-1}, (n - 1) - 1, g_{n-1})$ ou $\overline{q}(r_{n-1} - g_{n-1}, n - 2, g_{n-1})$, en faisant varier $g_{n-1}$ de $x_{n-1} + 1$ à $min(x_n, r_{n-1})$. La fonction min garantit que la norme $r_n$ et l'ordre $g_{n-1} \leq g_n = x_n$ soient respectés.

En étendant le résultat aux dimensions additionnelles, le nombre de leaders dont la plus grande coordonnée est égale à $x_n$, mais qui précèdent $l$ peut être obtenu par :

$$I_l = \sum_{\substack{j=1 \\ \text{tant que } x_{n-(j+1)} \neq 0}}^{n-2} \sum_{i=x_{n-j}+1}^{min[x_{n-(j-1)}, r_{n-j}]} \overline{q}(r_{n-j} - i, n - (j + 1), i)$$

$$(6)$$

La combinaison des équations (5) et (6) conduit à une formule générale pour calculer le nombre total de leaders placés avant $l$, et donc l'index $I_1$ de $l$ (équation (4)) :

$$I_l = \sum_{j=0}^{n-2} \sum_{i=x_{n-j}+1}^{\min[x_{n-(j-1)},\,r_{n-j}]} \overline{q}(r_{n-j}-i, n-(j+1), i)$$

$$\text{tant que } x_{n-(j+1)} \neq 0$$

où $x_{n+1} = +\infty$ pour $j = 0$.

3.2 Généralisation au cas d'une norme $l_p$

Afin de calculer l'index du leader $l = (x_1, x_2, ..., x_n)$ d'un vecteur $\mathbf{v} = (v_1, v_2, ..., v_n)$ situé sur une enveloppe de norme $l_p$ constante, avec $0 < p \leq 2$, on applique le même principe que dans le cas de $l_1$. Les leaders sont listés dans l'ordre lexicographique inverse et on attribue l'index en utilisant la même approche de dénombrement. Par conséquent, la structure de l'équation (4) est encore appropriée, où la somme sur i avec la fonction $\overline{q}$ calcule le nombre de leaders en fonction d'une coordonnée donnée et la somme sur j permet la récursion sur la dimension.

Cependant, l'utilisation de $\overline{q}$ entraîne implicitement que les termes de somme $x_i^p$ d'une norme r sont des entiers et peuvent être un entier quelconque dans l'intervalle [0, r]. Ceci est évidemment valide pour p = 1, où les termes de somme sont les coordonnées de réseau d'entier positif elles-mêmes. Par contre, pour $p \neq 1$, les termes de somme $x_i^p$ ne sont pas nécessairement des entiers ou ne peuvent pas être un entier quelconque dans l'intervalle [0, r] (par exemple, pour p = 2 les termes de somme sont des entiers, mais uniquement les nombres carrés).

Il est possible de résoudre ce problème en arrondissant $x_i^p$ à l'entier le plus proche avec une précision $\delta$. Une technique similaire a été utilisée dans [7, 9]. Cette opération introduit un nouveau sous-ensemble d'entiers $\mathcal{S}_\delta^p$ composé

$$\overline{x}_i = \left[\frac{x_i^p}{\delta}\right],$$

de tous les entiers $\overline{x}_i$, où          [·] étant l'entier le plus proche et $x_i \in Z^*$.

La norme $l_p$ d'un vecteur est alors connue avec une précision $\delta$ et est obtenue par :

$$r_{\delta,n}^p = \sum_{i=1}^n \overline{x}_i = \sum_{i=1}^n \left[\frac{x_i^p}{\delta}\right]$$

$$(7)$$

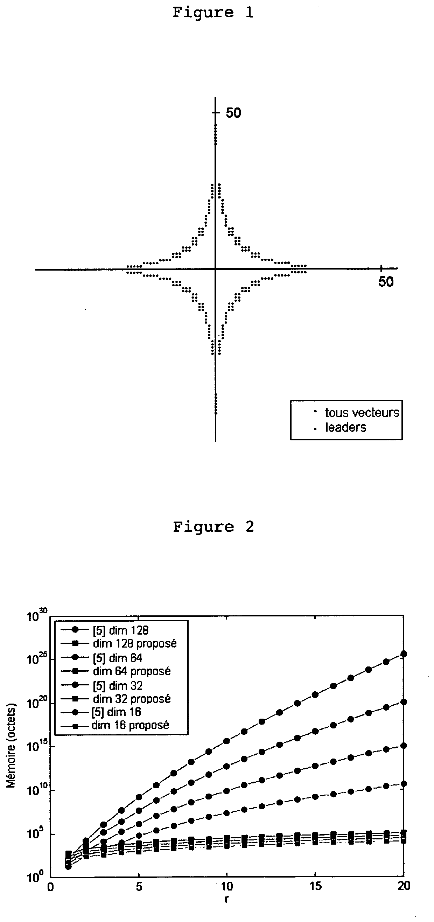

où la précision $\delta$ définit la largeur des enveloppes de norme constante $r_{\delta,n}^p$, comprenant plus de vecteurs au fur et à mesure que sa valeur augmente (voir Figure 2).

Figure 1 : exemple d'enveloppe de $r_{\delta,2}^p = 15$, p = 0,4 et $\delta$ = 0,3 pour un réseau $Z^2$.

En conséquence, le calcul de l'index de leader d'un vecteur dans une norme $l_p$ constante correspond au calcul du nombre correct de partitions d'un nombre entier mais en utilisant uniquement des entiers appartenant au sous-ensemble $\mathcal{S}_\delta^p$. La proposition mathématique numéro 2 décrit l'algorithme d'indexage pour le cas $l_p$ :

Proposition 2. Soit $\mathbf{v} = (v_1, v_2, ..., v_n)$ un vecteur de réseau $Z^n$ avec un leader $l = (x_1, x_2, ..., x_n)$ situé sur une enveloppe de norme constante $l_p$. Son index de leader $I_1$ est donné par :

$$I_l = \sum_{\substack{j=0 \\ \text{tant que } x_{n-(j+1)} \neq 0}}^{n-2} \sum_{i=x_{n-j}+1}^{\min[x_{n-(j-1)},f(r_{\delta,n-j}^p)]} \overline{q}_\delta^p(r_{\delta,n-j}^p - t(i), n-(j+1), i)$$

$$+ \min(f(\overline{x}_1), x_2) - x_1$$

$$(8)$$

où $\overline{q}_\delta^p(r, d, k)$ calcule le nombre de partitions de $r \in \mathcal{S}_\delta^p$ avec au plus d parts inférieures ou égales à k $\in Z^*$, avec $\overline{q}_\delta^p(0, d, k) = 1$ et $x_{n+1} = +\infty$. f(a) retourne la valeur maximale i $\in Z^*$ de sorte que t(i) $\leq$ a,

pour a $\in \mathcal{S}_\delta^p$ et t(i) = $\left\lceil \dfrac{i^p}{\delta} \right\rceil$.

Démonstration : Considérons un leader l = ($x_1$, $x_2$, ..., $x_n$) de dimension n et de norme $l_p$ $r_n = \sum_{i=1}^n x_i^p$ devant être indexé. Comme décrit précédemment, on utilise le même principe que l'équation (4). Mais l'utilisation de la fonction $\overline{q}$ n'est plus possible, étant donné que les termes de somme d'une norme $l_p$, avec p $\neq$ 1, ne sont pas toujours des entiers.

L'arrondi de $x_i^p$ à l'entier le plus proche avec une précision $\delta$ permet d'obtenir une norme entière $r_{\delta,n}^p$ à partir d'une somme de valeurs entières positives $\overline{x}_i$, comme défini dans l'équation (7). Par conséquent, le calcul de l'index d'un leader l situé sur une enveloppe de p $\neq$ 1 avec une précision $\delta$ peut être effectué en comptant le nombre de façons différentes d'écrire $r_{\delta,n}^p = r$ comme étant la somme de $\overline{x}_i \in \mathcal{S}_\delta^p$, où $\mathcal{S}_\delta^p$ est l'ensemble d'image de la fonction t

$$t(x_i) = \overline{x}_i = \left\lceil \frac{x_i^p}{\delta} \right\rceil.$$

définie par t : $Z^* \rightarrow \mathcal{S}_\delta^p$ qui met en correspondance $x_i \rightarrow \overline{x}_i$ où

Il est ici important de noter que suivant les valeurs de p et $\delta$ la fonction t peut représenter une fonction non-injective, étant donné que différentes valeurs de $Z^*$ peuvent être mises en correspondance avec la même valeur dans $\mathcal{S}_\delta^p$. En conséquence, différents leaders l $\in Z^{n*}$ peuvent avoir la même représentation dans $\mathcal{S}_\delta^{pn}$ et n'importe quelle procédure naïve pour compter le nombre de partitions dans $\mathcal{S}_\delta^{pn}$ conduirait non seulement à un index de leader erroné mais également à attribuer le même index erroné à des leaders distincts.

Nous définissons en tant que solution la fonction $\overline{q}_\delta^p(r, d, k)$ comme étant la fonction qui compte le nombre de partitions de $r \in \mathcal{S}_\delta^p$ avec au plus d parts, où une part est donnée par $t(i) \in \mathcal{S}_\delta^p$, avec aucun i supérieur à k, pour i, k $\in Z^*$. Il doit être noté que la contrainte sur la valeur de la plus grande part dans $\mathcal{S}_\delta^p$ en utilisant indirectement une valeur k de $Z^*$ permet de compter le nombre de leaders différents qui conduisent à une même partition dans $\mathcal{S}_\delta^{pn}$.

Par conséquent, en utilisant $\overline{q}_\delta^p(r, d, k)$, l'équation (4) peut être étendue pour des normes $l_p$ par :

$$I_l = \sum_{\substack{j=0 \\ \text{tant que } x_{n-(j+1)} \neq 0}}^{n-2} \sum_{i=x_{n-j}+1}^{\min[x_{n-(j-1)},f(r_{\delta,n-j}^p)]} \overline{q}_\delta^p(r_{\delta,n-j}^p - t(i), n-(j+1), i)$$

$$(9)$$

où f(a) retourne la valeur maximale i $\in Z^*$ de sorte que t(i) $\leq$ a, pour $a \in \mathcal{S}_\delta^p$ .

En faisant varier j de 0 à n - 2 dans l'équation (9) on compte correctement le nombre de leaders précédant 1 pour les coordonnées $x_n$ à $x_2$. Dans le cas de la norme $l_1$, c'est une condition suffisante pour calculer le nombre total de leaders précédents, étant donné qu'il existe une seule valeur $x_1 \in Z^*$ pour laquelle $x_1 + \sum_{i=2}^{n} x_i = r_n$ . Cependant, pour la norme $l_p$, il est possible que plusieurs valeurs $x_1 \in Z^*$ conduisent à $\overline{x}_1 + \sum_{i=2}^{n} \overline{x}_i = r_{\delta,n}^p$ en raison de la non-injection de là fonction t. Par conséquent, afin de garantir l'unicité de l'index, on calcule le décalage entre $\min(f(\overline{x}_1), x_2)$ et $x_1$ et ajoutons celui-ci au résultat de l'équation (9), pour obtenir l'index de leader décodable unique donné par l'équation (8) :

$$I_l = \sum_{\substack{j=0 \\ \text{tant que } x_{n-(j+1)} \neq 0}}^{n-2} \sum_{i=x_{n-j}+1}^{\min[x_{n-(j-1)}, f(r_{\delta,n-j}^p)]} \overline{q}_\delta^p (r_{\delta,n-j}^p - t(i), n-(j+1), i)$$

$$+ \min(f(\overline{x}_1), x_2) - x_1$$

La fonction min est requise étant donné que $f(\overline{x}_1)$ peut être supérieur à $x_2$ alors que $x_1$ doit être plus petit que ou égal à $x_2$.

Le calcul de $\overline{q}_\delta^p (r, d, k)$ est fait à l'aide d'un algorithme de dénombrement. Dans la section suivante nous exposons l'algorithme qui fait l'objet de l'invention.

3.3 : Algorithme de dénombrement

La fonction $\overline{q}_\delta^p$ proposée est définie comme étant l'équivalent du nombre de partitions de la norme $r_{\delta,d}^p = r$ avec au plus d parts et avec la plus grande part t(i) avec i $\leq$ k. Par conséquent, nous calculons $\overline{q}_\delta^p (r, d, k)$ avec une récursion dans la dimension comme suit :

$$\overline{q}_\delta^p (r, d, k) = \sum_{i=i_{\min}(r,d)}^{k} \overline{q}_\delta^p (r - t(i), d - 1, i) \qquad (10)$$

où imin(r, d) retourne la valeur minimale de i $\in Z^*$ satisfaisant à $t(i) \geq \left\lceil \frac{r}{d} \right\rceil$ . Celle-ci représente la plus grande part de la dernière partition de norme $r_{\delta,d}^p = r$ et de dimension d dans l'ordre lexicographique inverse.

Pour la dimension d = 1, $\overline{q}_\delta^p (r, 1, k)$ est initialisé avec le nombre d'entiers positifs différents i $\leq$ k de sorte que t(i) = r. Par exemple, pour p = 0,5 et $\delta$ = 0,1, nous définissons $\overline{q}_\delta^p (57, 1, k)$ à 0 si k $\leq$ 31, à 1 si k = 32 et à 2 si k $\geq$ 32, étant donné que r = 57 est mis en correspondance dans $\mathcal{S}_{0.1}^{0.5}$ en utilisant la fonction t uniquement sur i = 32 et $i = 33 \left( t(32) = \left\lceil \frac{32^{0.5}}{0.1} \right\rceil = t(33) = \left\lceil \frac{33^{0.5}}{0.1} \right\rceil = 57 \right)$ .

Il doit être noté que la fonction $\overline{q}_\delta^p$ est la généralisation de la fonction $\overline{q}$, étant donné que pour p = 1 et $\delta$ = 1

## EP 2 289 172 B1

nous avons $\mathcal{S}_\delta^p = Z^*$.

Les algorithmes 1 et 2 présentés dans l'annexe initialisent et calculent $\overline{q}_\delta^p(r, 1, k)$.

3 .4. Coût de mémoire

Dans le cas où $\overline{q}_\delta^p(r, d, k)$ n'est pas calculé en ligne, les besoins de mémoire peuvent être calculés comme décrit ci-après.

Le $\overline{q}_\delta^p$ stocké peut être interprété comme étant une table tridimensionnelle, où la première entrée est la valeur $r \in \mathcal{S}_\delta^p$, la deuxième est la dimension $d \in Z^+$ et la troisième est la valeur de réseau maximale $k \in Z^*$. Le besoin de mémoire maximal prévu est alors $r \cdot d \cdot k \cdot B$ octets, où B est le nombre d'octets par élément de $\overline{q}_\delta^p$.

Cependant, la limite pour les étapes de codage et de décodage effectives pour une norme maximale donnée $r_{\delta,n}^p = r$ et une dimension d est plus faible. En effet, à partir des équations (8) et (10), il peut être observé que la plus grande valeur des deux premières variables d'entrée de $\overline{q}_\delta^p$ est obtenue lorsque j = 0 et i = imin(r, d). Dans ce cas, nous calculons $\overline{q}_\delta^p(r - t(imin(r, d), d-1, imin(r, d)) = q_\delta^p(r - \left[\dfrac{r}{d}\right], d-1, imin(r, d))$. Par conséquent, il suffit d'utiliser la première variable d'entrée (liée à la norme) sur l'intervalle $\left[0, r - \left[\dfrac{r}{d}\right]\right]$ et la deuxième (liée à la dimension) sur l'intervalle [1, d - 1].

La valeur de k peut être déterminée à partir de r. Étant donné que la deuxième contrainte n'est requise que si $t(k) \leq \dfrac{r}{2}$, la valeur maximale de k peut être définie à k = $f\left(\dfrac{r}{2}\right)$ afin d'indexer un leader quelconque ayant une norme dans l'intervalle [0, r] et une dimension [1, d]. Par conséquent, la limite supérieure de coût de mémoire pour les étapes de codage et de décodage est donnée par :

$$\# M = \left(\left(r - \left[\dfrac{r}{d}\right]\right) + 1\right) \times (d - 1) \times \left(f\left(\left\lfloor\dfrac{r}{2}\right\rfloor\right) + 1\right) \cdot B \quad \text{octets}$$

$$(13)$$

Il doit être noté que le besoin de mémoire dépend principalement de la norme et de la dimension des enveloppes. Le nombre de leaders détermine le choix de B.

La figure 3 illustre l'économie de mémoire en utilisant l'algorithme d'indexage avec la table $\overline{q}_\delta^p$ calculée hors ligne. Le besoin de mémoire est représenté à partir de l'équation (13) en fonction du rayon r pour p = 1, $\delta$ = 1 et B = 4 (c'est-à-dire, des données de type entier) et est comparé à la limite supérieure de mémoire des méthodes classiques basées sur les leaders comme décrit dans [5]. Il doit être noté que même pour une dimension et un rayon aussi faible que 16 et 20, respectivement, les méthodes classiques ne requièrent pas plus de 10 gigaoctets de mémoire tandis que la méthode proposée nécessite moins de 100 kilo-octets.

Les besoins de mémoire extrêmement faibles et le fait qu'il n'est pas nécessaire de connaître tous les leaders permettent d'indexer les vecteurs de réseau dans des dimensions aussi élevées que 64, 128, 256, 512, etc. Dans les travaux antérieurs, les applications pratiques étaient limitées à une dimension de 16.

ANNEXE

ALGORITHMES DE DENOMBREMENT

ALGORITHME 1

/* Construction du tableau $\overline{q}_\delta^p$ [r][d][k]. Pour une valeur de norme maximale $r_{\delta,d}^p$ = r et dimension d, cet algorithme crée le tableau 3-D $\overline{q}_\delta^p$ de dimensions $((r-\lceil r/d\rceil)-1)\times(d-1)\times((f(\lfloor r/2\rfloor))-1)$. */

```
r_bckp = r;
k = f[floor((double)r/2.)];
r = r-ceil((double)r/(double)d);
d--;
{q̄_δ^p,f,t} = init(r_bckp,r,d,k);// Initialises q̄_δ^p
for(j=1;j<d;j++)
{
        for(R=1;R<=r;R++)
        {
        N_p = 0;
        for(i=imin(R,j+1);i<=f[R];i++)
{
        rmd = R-t[i];
        if(t[i]>rmd)// Pas de deuxième contrainte
        N_p += q̄_δ^p[rmd][j-1][0];
        else
        N_p += q̄_δ^p[rmd][j-1][i];
        if(i<=k)
        q̄_δ^p[R][j][i] = N_p;    // Valeurs avec
        }                               // deuxième contrainte
        q̄_δ^p [R][j][0] = N_p;// Valeurs sans deuxième contrainte
        }
}
return ¹q̄_δ^p;// La fonction termine ici
```

/* La fonction init($r_{bckp}$,r,d,k) est détaillée dans l'Algorithme 2.
La fonction imin(r,d) retourne la plus petite valeur i∈Z*

tel que $\left\lceil\dfrac{i^p}{\delta}\right\rceil \geq \left\lceil\dfrac{r}{d}\right\rceil$ (Voir l'Equation (???).) */

ALGORITHME 2

```
/* Fonction init(r_bckp,r,d,k) qui sert à l'initialisation du
tableau q̄_δ^p [r][d][k] et à la création des vecteurs f et t
utilisés dans l'Algorithmes 1.*/


q̄_δ^p = 0_{r+1,d,k+1};     //Tableau de zéros de dimension(r+1)×d×(k+1)
f = 0_{rbckp+1};          // Vecteur de zéros de dimension r_bckp + 1
t = 0_{f(rbckp)+2};       // Vecteur de zéros de dimension f(r_bckp) + 2
f[r_bckp] = f(r_bckp);
for(i=0;i<=f[r_bckp];i++)
{
        do{
        if(t[i]<=r)
        {
        q̄_δ^p[t[i]][0][0]++;// ᵃ
        if(i<=k)
        q̄_δ^p[t[i]][0][i] = q̄_δ^p[t[i]][0][0];// ᵇ
        }
        i++;
        t[i] = t(i);
        }while(t[i]==t[i-1]);
        i--;
        f[t[i]] = f(t[i]);
        for(j=t[i]+1;j<min(t[i+1],r_bckp);j++)
        f[j]= f[t[i]];
}
for(j=1;j<d;j++)// ᶜ
q̄_δ^p[0][j][0] = 1;

return {q̄_δ^p,f,t};// La fonction termine ici
```

/*ᵃ Initialise q̄_δ^p pour la première dimension sans deuxième
contrainte pour toutes les normes de 0 à r.
ᵇ Initialise q̄_δ^p pour la première dimension avec deuxième
contrainte de imin(t(i),1) a f(t(i)) pour toutes les normes
de 0 à r.
ᶜ Initialises q̄_δ^p toutes les dimensions au-delà de la
première sans deuxième contrainte et pour la norme 0.
Les vecteurs f et t sont initialisés en utilisant les
fonctions f et t respectivement.*/

ANNEXE 2

Références Bibliographiques

[1] CONWAY J.H. and SLOANE N.J.A., "Fast quantizing and decoding algorithms for lattice quantizers and codes" IEEE Transaction on Information Theory, March 1982.

[2] J. Conway and N. Sloane, "Sphere packings, lattices and groups". Springer Verlag, 1988.

[3] T. R. Fischer, "A pyramid vector quantizer," IEEE Trans. Inform. Theory, vol. 32, pp. 568-583, July 1986.

[4] P. Loyer, J. Moureaux, and M. Antonini, "Lattice codebook enumeration for generalized gaussian source," IEEE Trans. Inform. Theory, vol. 49, no. 2, pp. 521-528, Feb. 2003.

[5] J. Moureaux, P. Loyer, and M. Antonini, "Low complexity indexing method for Zn and Dn lattice quantizers," IEEE Trans. Commun.,vol. 46, no. 12, pp. 1602-1609, december 1998.

[6] C. Lamblin and J. P. Adoul, "Algorithme de quantification vectorielle sphrique partir du rseau de gosset dordre 8," Ann. Telecommun., vol. 43, no. 3/4, pp. 172-186, 1988.

[7] R. Laroia and N. Farvardin, "A structured fixed-rate vector quantizer derived from a variable length scalar quantizer - part I: Memoryless sources," IEEE Trans. Inform. Theory, vol. 35, pp. 851-867, 1991.

[8] A. Vasilache, B. Dumitrescu, and I. Tabus, "Multiple-scale leader-lattice VQ with application to LSF quantization," Signal Processing, vol. 82, no. 4, p. 563586, 2002.

[9] F. Chen, Z. Gao, and J. Villasenor, "Lattice vector quantization of generalized gaussian sources," IEEE Trans. Inform. Theory, vol. 43, pp. 92-103, Jan. 1997.

[10] G. E. Andrews, "The Theory of Partitions", reprint ed. Cambridge University Press, July 1998.

[11] M. Barlaud, P. Solé, T. Gaidon, M. Antonini, and P. Mathieu, "Pyramidal lattice vector quantization for multiscale image coding," IEEE Trans. Image Processing, vol. 3, no. 4, pp. 367-381, july 1994.

[12] Z. Gao, F. Chen, B. Belzer, and J. Villasenor, "A comparison of the Z, E8, and leech lattices for quantization of low-shape-parameter generalized gaussian sources," IEEE Signal Processing Letters, vol. 2, pp. 197-199, October 1995.

[13] P. Rault and C. Guillemot, "Indexing algorithms for Zn, An, Dn and Dn++ lattice vector izers," IEEE Trans. Multimedia, vol. 3, no. 4, pp 30-404, Dec. 2001.

[14] M. Mejdoub, L. H. Fonteles, C. B. Amar, and M. Antonini, "Fast algorithm for image database indexing based on lattice," Proceedings of European Signal Processing Conférence (EUSIPCO), September 2007.

[15] J. P. M. Schalkwijk, "An algorithm for source coding," IEEE Trans. Inform. Theory, vol. 18, pp. 395-399, May 1972.

[16] Eric W. Weisstein, "Partition Function P," From MathWorld - A Wolfram Web Resource. [Online]. Available: http://mathworld.wolfram.com/PartitionFunctionP.html

[17] -, "q-Series," From MathWorld - A Wolfram Web Resource. [Online]. Available: http://mathworld.wolfram.com/q-Series.html

[18] -, "Partition Function q," From MathWorld - A Wolfram Web Resource. [Online]. Available: http://mathworld.wolfram.com/PartitionFunctionq.html

**Revendications**

1. Procédé mis en oeuvre par ordinateur d'estimation du nombre de vecteurs leaders de dimension d et dont les coordonnées sont inférieures ou égales à k, les dits vecteurs leaders étant situés sur une enveloppe de norme $l_p$, avec $0 < p \le 2$, la dite norme lp étant constante et égale à $r_{\delta,d}^{p} = r$ où $\delta$ est un facteur de précision, **caractérisé**

**en ce que** :

$r_{\delta,d}^p$ est déterminé par la sommation des résultats d'une fonction t(x$_i$) pour i variant entre 1 et d, ladite fonction t(x$_i$) retournant le résultat de la division de la coordonnée x$_i$ élevé à la puissance p par $\delta$, le résultat de ladite division étant arrondi à l'entier le plus proche ;

• calcul de la fonction $\overline{q}_\delta^p (r, d, k)$ retournant la quantité de vecteurs leaders par récursion dans la dimension d selon l'équation

$$\overline{q}_\delta^p (r,d,k) = \sum_{i=imin(r,d)}^{k} \overline{q}_\delta^p \begin{pmatrix} r - t(i), d - 1 \\ , i \end{pmatrix}$$

ladite fonction i$_{min}$ retournant la plus petite valeur entière i qui vérifie t(i) supérieur ou égal à r/d ; et
• et tel que la taille de mémoire de l'ordinateur nécessaire pour le stockage des valeurs successives de la fonction $\overline{q}_\delta^p \cdot$ est au plus celle d'une table tridimensionnelle de dimension (r, d, k) .

2. Procédé d'estimation du nombre de vecteurs leaders selon la revendication 1, **caractérisé en ce que** l'on procède à une étape préalable d'initialisation de la récursion consistant à attribuer, pour n=l, à la fonction $\overline{q}_\delta^p (\text{r}, \ 1, \ k)$ une valeur correspondant au nombre des valeurs possibles de u plus petites ou égales à k telles que t(u)=r.

3. Application du procédé d'estimation selon l'une au moins des revendications 1 à 2, pour l'estimation du débit dans le cadre de compression de données.

4. Application du procédé d'estimation selon l'une au moins des revendications 1 à 2, pour l'indexation de vecteurs leaders.


**Patentansprüche**

1. Verfahren zur Durchführung mit dem Computer einer Schätzung der Anzahl von Leitvektoren mit der Abmessung d, und deren Koordinaten kleiner oder gleich k sind, wobei sich die Leitvektoren auf einer Hüllkurve der Norm 1$_p$ befinden, mit 0 < p ≤ 2, wobei die Norm 1p konstant oder gleich $r_{\delta,d}^p = r$ ist, wobei $\delta$ ein Präzisionsfaktor ist, **dadurch gekennzeichnet, dass**:

- $r_{\delta,d}^p$ durch die Summierung der Ergebnisse einer Funktion t(x$_i$) bestimmt wird, bei der i zwischen 1 und d variiert, wobei die Funktion t(x$_i$) das Ergebnis der Division der Koordinate x$_i$ potenziert mit p durch $\delta$ umkehrt, wobei das Ergebnis der Division auf die nächste ganze Zahl gerundet wird,

- Berechnen der Funktion $\overline{q}_\delta^p (r, d, k)$, die die Anzahl von Leitvektoren durch Rekursion auf die Dimension d gemäß der Gleichung

$$\overline{q}_\delta^p (r,d,k) = \sum_{i=imin(r,d)}^{k} \overline{q}_\delta^p \begin{pmatrix} r - t(i), d - 1 \\ , i \end{pmatrix}$$

umkehrt, wobei die Funktion i$_{min}$ den kleinsten ganzen Wert i umkehrt, der t(i) größer oder gleich als r/d bewertet; und
- die Größe des Computerspeichers, die für die Speicherung der aufeinander folgenden Werte der Funktion $\overline{q}_\delta^p \cdot$ erforderlich ist, höchstens diejenige einer dreidimensionalen Tabelle mit der Abmessung (r, d, k) ist.

**2.** Verfahren zum Schätzen der Anzahl von Leitvektoren nach Anspruch 1, **dadurch gekennzeichnet, dass** ein vorheriger Schritt der Initialisierung der Rekursion durchgeführt wird, die darin besteht, für n=1 der Funktion $\overline{q}_{\delta}^{p}$ $(\text{r, l, k})$ einen Wert zuzuweisen, der der Anzahl der möglichen Werte von u entspricht, die kleiner oder gleich k sind, wie z. B. t(u)=r.

**3.** Anwendung des Verfahrens zum Schätzen nach mindestens einem der Ansprüche 1 bis 2 zum Schätzen des Durchsatzes im Rahmen der Komprimierung von Daten.

**4.** Anwendung des Verfahrens zum Schätzen nach mindestens einem der Ansprüche 1 bis 2 zur Indexierung der Leitvektoren.

**Claims**

**1.** A computer implemented method for estimating the number of leader vectors of dimension d and the co-ordinates of which are lower than or equal to k, said leader vectors being situated on an envelope of norm $l_p$, with $0 < p \leq 2$, the said norm $l_p$ being constant and equal to $r_{\delta,d}^{p} = r$ where $\delta$ is a precision factor, **characterized in that**:

- $r_{\delta,d}^{p}$ is determined by the sum of the results of a function $t(x_i)$ for i varying between 1 and d, said function $t(x_i)$ providing the result of the division of the co-ordinate $x_i$ raised to the power p by $\delta$, the result of said division being rounded to the nearest whole number;
- calculation of the function $\overline{q}_{\delta}^{p}(r, d, k)$ providing the quantity of leader vectors with a recursion in the dimension d following the equation

$$\overline{q}_{\delta}^{p}(r, d, k) = \sum_{i=imin(r,d)}^{k} \overline{q}_{\delta}^{p}\begin{pmatrix} r - t(i), d - 1 \\ , i \end{pmatrix}$$

said function $i_{min}$ providing the smallest integer value i that satisfies t(i) greater than or equal to r/d; and
- and such that the size of the computer memory required for the storage of successive values of the function $\overline{q}_{\delta}^{p}$ is at most that of a three-dimensional table (r, d, k).

**2.** A method for estimating the number of leader vectors according to claim 1, **characterized in that** a prior initialization step of the recursion is carried out, consisting in attributing, for n=1, to the function $\overline{q}_{\delta}^{p}(\text{r, } 1, k)$ a value corresponding to the number of possible values of u smaller than or equal to k, such that t(u)=r.

**3.** The application of the estimation method according to at least one of claims 1 to 2, for estimating the rate in the context of data compression.

**4.** The application of the estimation method according to at least one of claims 1 to 2 for indexing leader vectors.

Figure 1

Figure 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- WO 9933185 A

### Littérature non-brevet citée dans la description

- **P. LOYER et al.** Lattice Codebook Enumeration for Generalised Gaussian Source. *IEEE Transactions on Information Theory,* 2003, vol. 49 (2
- **CONWAY ; SLOANE.** Fast quantizing and decoding algorithms for lattice quantizers and codes. *IEEE Trans. On Information Theory,* Mars 1982, vol. 28 (2), 227-232
- **CONWAY J.H. ; SLOANE N.J.A.** Fast quantizing and decoding algorithms for lattice quantizers and codes. *IEEE Transaction on Information Theory,* Mars 1982
- **J. CONWAY ; N. SLOANE.** Sphere packings, lattices and groups. Springer Verlag, 1988
- **T. R. FISCHER.** A pyramid vector quantizer. *IEEE Trans. Inform. Theory,* Juillet 1986, vol. 32, 568-583
- **P. LOYER ; J. MOUREAUX ; M. ANTONINI.** Lattice codebook enumeration for generalized gaussian source. *IEEE Trans. Inform. Theory,* Février 2003, vol. 49 (2), 521-528
- **J. MOUREAUX ; P. LOYER ; M. ANTONINI.** Low complexity indexing method for Zn and Dn lattice quantizers. *IEEE Trans. Commun.,* Décembre 1998, vol. 46 (12), 1602-1609
- **C. LAMBLIN ; J. P. ADOUL.** Algorithme de quantification vectorielle sphrique partir du rseau de gosset dordre 8. *Ann. Telecommun.,* 1988, vol. 43 (3/4), 172-186
- **R. LAROIA ; N. FARVARDIN.** A structured fixed-rate vector quantizer derived from a variable length scalar quantizer - part I: Memoryless sources. *IEEE Trans. Inform. Theory,* 1991, vol. 35, 851-867
- **A. VASILACHE ; B. DUMITRESCU ; I. TABUS.** Multiple-scale leader-lattice VQ with application to LSF quantization. *Signal Processing,* 2002, vol. 82 (4), 563586
- **F. CHEN ; Z. GAO ; J. VILLASENOR.** Lattice vector quantization of generalized gaussian sources. *IEEE Trans. Inform. Theory,* Janvier 1997, vol. 43, 92-103
- **G. E. ANDREWS.** The Theory of Partitions. Cambridge University Press, Juillet 1998
- **M. BARLAUD ; P. SOLÉ ; T. GAIDON ; M. ANTONINI ; P. MATHIEU.** Pyramidal lattice vector quantization for multiscale image coding. *IEEE Trans. Image Processing,* Juillet 1994, vol. 3 (4), 367-381
- **Z. GAO ; F. CHEN ; B. BELZER ; J. VILLASENOR.** A comparison of the Z, E8, and leech lattices for quantization of low-shape-parameter generalized gaussian sources. *IEEE Signal Processing Letters,* Octobre 1995, vol. 2, 197-199
- **P. RAULT ; C. GUILLEMOT.** Indexing algorithms for Zn, An, Dn and Dn++ lattice vector izers. *IEEE Trans. Multimedia,* Décembre 2001, vol. 3 (4), 30-404
- **M. MEJDOUB ; L. H. FONTELES ; C. B. AMAR ; M. ANTONINI.** Fast algorithm for image database indexing based on lattice. *Proceedings of European Signal Processing Conférence (EUSIPCO),* Septembre 2007
- **J. P. M. SCHALKWIJK.** An algorithm for source coding. *IEEE Trans. Inform. Theory,* Mai 1972, vol. 18, 395-399
- **ERIC W. WEISSTEIN.** Partition Function P. *From MathWorld - A Wolfram Web Resource, http://mathworld.wolfram.com/PartitionFunctionP.html*
- q-Series. *From MathWorld - A Wolfram Web Resource, http://mathworld.wolfram.com/q-Series.html*
- Partition Function q. *From MathWorld - A Wolfram Web Resource, http://mathworld.wolfram.com/PartitionFunctionq.html*